# EUROPÄISCHE PATENTSCHRIFT

(11) **EP 2 206 150 B1**
(45) Veröffentlichungstag und Bekanntmachung des Hinweises auf die Patenterteilung: **06.07.2011**
(21) Anmeldenummer: 09726427.9
(22) Anmeldetag: 08.04.2009
(51) Int. Cl.: H01L 25/16, F21K 99/00, H01L 33/48, H01L 33/62, H01L 33/64

(54) **ANSCHLUSSFERTIGER LED-MODULKÖRPER**
READY-TO-CONNECT LED MODULE BODY
CORPS MODULAIRE DE DIODE DEL PRET A RACCORDER

(30) Priorität: 21.11.2008 DE 102008058494
(43) Veröffentlichungstag der Anmeldung: 14.07.2010
(73) Patentinhaber: RZB Rudolf Zimmermann, Bamberg GmbH, 96052 Bamberg (DE); Neumüller Elektronik GmbH, 91085 Weisendorf (DE)
(72) Erfinder: FISCHER, Uwe, 91085 Weisendorf (DE); DRAWERT, Sergio, 96114 Hirschaid-Sassanfahrt (DE)
(74) Vertreter: Meissner, Bolte & Partner
(86) Internationale Anmeldenummer: PCT/EP2009/054181
(87) Internationale Veröffentlichungsnummer: WO 2010/057682

(56) Entgegenhaltungen:
- WO-A-2006/095949
- DE-U1-202007 007 581

## Beschreibung

Die Erfindung betrifft einen anschlussfertigen LED (lichtemittierende Dioden)-Modulkörper, umfassend mindestens einen lichtemittierenden Diodenchip, welcher auf einem flächenförmigen Verdrahtungsträger angeordnet ist, wobei der mindestens eine Diodenchip mit einem elektrisch isolierenden, lichtdurchlässigen, elastischen oder plastischen Kapselmaterial abgedeckt ist, sowie mit auf dem Verdrahtungsträger befindlichen Anschlussfeldern, die mit dem Diodenchip in elektrischer Verbindung stehen, gemäß Oberbegriff des Patentanspruchs 1.

Aus der DE 20 2008 009 797 U1 ist ein LED-basierender Beleuchtungskörper vorbekannt, welcher aus mindestens einem Modul besteht, der ein optisches System sowie eine lichttransparente Abdeckung aufweist. Das optische System umfasst mindestens eine LED und einen den Lichtaustrittskegel der LED überspannenden Reflektor mit speziellen Facetten, die sich derart in einem bestimmte Winkel zueinander erstrecken, dass das von der LED emittierte Licht im Wesentlichen über die Facetten des Reflektors zur Lichtnutzebene umgelenkt wird.

Dieser vorbekannte LED-basierende Beleuchtungskörper ist sowohl für die Beleuchtung und Ausstrahlung von Innenräumen als auch für Außenanwendungen konzipiert. Zur Vermeidung von Schmutzablagerungen und Alterungserscheinungen ist das aus dem optischen System und der lichttransparenten Abdeckung aufgebaute Modul gekapselt. Mehrere Module können innerhalb eines LED-basierenden Beleuchtungskörpers eingesetzt werden. Diese sind dann vorzugsweise matrixartig in Spalten und Reihen zueinander angeordnet und entsprechend verschaltet. Eine vorhandene Rückseite einer Trägerplatine besitzt eine zum Zweck der verbesserten Wärmeabfuhr vorgesehene Wärmeleitschicht in Form einer Kupfer- oder Aluminium-Leitfolie. Wenn eine solche LED-Anordnung unmittelbar am Netz betrieben werden soll, ist für einen ausreichenden Berührungsschutz unter Beachtung sonstiger Schutzartbestimmungen Sorge zu tragen. Ein Betrieb am Niederspannungsnetz, z.B. im Bereich 220 V bis 400 V, erfordert eine Reihenschaltung einer Vielzahl von Modulen mit jeweils Bypassdioden, um bei Ausfall eines Moduls noch eine Funktionserhaltung zu gewährleisten.

Bei dem Leistungs-LED-Modul nach DE 20 2005 012 652 U1 ist mindestens eine Leistungs-LED auf einer Platine angeordnet. Darüber hinaus ist ein zur Kühlung der LED vorgesehener Kühlkörper aus Metall vorhanden. Die Platine ist in einem unter der LED liegenden Bereich mit einem Durchgangsloch versehen, in das der Kühlkörper an der rückseitigen Kontaktfläche der LED anliegend eingesetzt ist. Bei dieser Lösung ist es also notwendig, eine spezielle Aussparung in der Platine vorzusehen, um einen wärmeleitenden Kontakt zwischen dem Kühlkörper und der eigentlichen lichtemittierenden Diode herzustellen. Insbesondere bei keramischen Verdrahtungsträgern bzw. Platinen kann ein derartiges Loch nur im sogenannten grünen Zustand der Keramik eingebracht werden. Beim Brennen bzw. Sintern der Keramik kommt es jedoch aufgrund des Sinterprozesses zu Dimensionsänderungen mit der Folge, dass Schwierigkeiten bei der exakten Positionierung beim Einsetzen des Kühlkörpers in die entsprechenden Durchgangslöcher resultieren.

Beim dem LED-Modul nach der DE 20 2007 007 581 U1 ist ein voluminöser Kühlkörper vorhanden, der eine obere Ausnehmung in einer Oberseite, eine Nut in der oberen Ausnehmung und eine Mehrzahl von Montagedurchgangslöchern aufweist, die durch die oberen und unteren Seiten im Kühlkörper eingebracht, insbesondere gebohrt sind. In der Nut des Kühlkörpers befindet sich ein lichtemittierender Diodenchip. Weiterhin ist eine Mehrzahl von Leiterplatten aus Metall vorhanden, die an dem Kühlkörper an der Unterseite befestigt werden. Die Leiterplatten weisen einen aufrecht stehenden Bolzen auf, der an den Montagedurchgangslöchern des Kühlkörpers jeweils befestigt ist. Diese Bolzen übernehmen dann die elektrische Kontaktierung. Die vorstehend beschriebene Baueinheit wird mindestens im Bereich der Nut, wo sich der Diodenchip befindet, mit einem lichtdurchlässigen Harz gekapselt. Ergänzend besteht die Möglichkeit, eine linsenförmige Abdeckhaube mit einem entsprechenden Schnapphalter am Modul zu fixieren. Auch mit dieser vorgestellten Ausführung eines LED-Moduls gelingt es nicht, den notwendigen Schutzgrad insbesondere beim Betreiben an Niederspannungsnetzen ohne weitere und zusätzliche Maßnahmen zu gewährleisten.

Die WO 2006/095949 A1 offenbart einen LED-Modul nach dem Oberbegriff des Anspruchs 1.

Aus dem Vorgenannten ist es daher Aufgabe der Erfindung, einen weiterentwickelten, anschlussfertigen LED-Modulkörper, umfassend mindestens einen lichtemittierenden Diodenchip, welcher auf einem flächenförmigen Verdrahtungsträger angeordnet ist, zu schaffen, welcher aus wenigen Teilen besteht, der in einfacher Weise an eine Leuchte angebracht oder in diese integriert werden kann und der über den notwendigen Berührungsschutz verfügt und damit unmittelbar zum Betreiben an einem Niederspannungsnetz geeignet ist.

Die Lösung der Aufgabe der Erfindung erfolgt durch einen anschlussfertigen LED-Modulkörper gemäß der Merkmalskombination nach Patentanspruch 1, wobei die Unteransprüche mindestens zweckmäßige Ausgestaltungen und Weiterbildungen darstellen.

Es wird demnach von einem anschlussfertigen LED-Modulkörper ausgegangen, umfassend mindestens einen lichtemittierenden Diodenchip, welcher auf einem flächenförmigen Verdrahtungsträger angeordnet ist. Der mindestens eine Diodenchip ist gegebenenfalls mindestens teilweise von einem Reflektor umgeben und wird mit einem elektrisch isolierenden, lichtdurchlässigen, elastischen oder plastischen Kapselmaterial abgedeckt. Auf dem Verdrahtungsträger befinden sich darüber hinaus Anschlussfelder, die mit dem Diodenchip in elektrischer Verbindung stehen. Diese elektrische Verbindung kann z.B. durch sogenanntes Chipbonden realisiert werden.

Erfindungsgemäß sind die Anschlussfelder mit einem flexiblen oder starren, externen Anschlussmittel kontaktiert. Dieses Kontaktieren kann z.B. durch einen Lötvorgang erfolgen.

Auf dem Verdrahtungsträger befindet sich darüber hinaus mindestens ein stromsteuerndes oder strombegrenzendes Element, z.B. ein Vorwiderstand für den mindestens einen Diodenchip, um über die Anschlussmittel einen unmittelbaren Betrieb an einem üblichen elektrischen Niederspannungsnetz zu ermöglichen.

Weiterhin ist ein Verguss- oder Verspritzblock gebildet, welcher bei einer Ausführungsform die Unterseite des Verdrahtungsträgers als thermische Koppelfläche und einen oberseitigen Abschnitt mit dem Kapselmaterial frei lässt. Ansonsten umschließt der Verguss- oder Verspritzblock den Verdrahtungsträger vollständig unter Einbindung eines Abschnitts der Anschlussmittel. Hierdurch ist der gewünschte Berührungsschutz, insbesondere im Bereich der Anschlussfelder gewährleistet. Gleichzeitig bewirkt der Verguss- oder Verspritzblock einen Knickschutz und eine Zugentlastung hinsichtlich der externen Anschlussmittel.

Weiterhin weist der Verguss- oder Verspritzblock außerhalb des flächenförmigen Verdrahtungsträgers mindestens ein Mittel zur Befestigung auf, wobei eine freie Unterseite des Verdrahtungsträgers eine Kühlfläche bildet.

Aus dem Vorgenannten ist ersichtlich, dass der Verguss- oder Verspritzblock eine Unterseite, ausgebildet als wärmeleitende Platte, frei lässt oder Freiflächen umfasst. Damit kann eine optimale Wärmeabstrahlung oder Kopplung zu einer Wärmesenke erfolgen und es kommt nicht zu einer nachteiligen Überhitzung des halbleitenden-pn-Übergangs im Diodenchip. Bei einer bevorzugten Ausführungsform ist das Material des Verguss- oder Verspritzblocks leicht elastisch und kann sich an die Oberfläche anformen bzw. anschmiegen, an die der Modulkörper durch z.B. Schrauben oder Nieten angebracht wird. Bevorzugt ist die Oberfläche, die mit der freien Unterseite des Verdrahtungsträgers in Kontakt kommt, gut wärmeleitend. Diese wärmeleitende Oberfläche kann z.B. eine metallische Komponente eines Leuchtenkörpers oder aber auch ein separater Kühlkörper sein.

Um den gewünschten Berührungsschutz zu gewährleisten, besteht das Verguss- oder Verspritzblockmaterial aus einem elektrisch isolierenden Stoff oder Stoffgemisch.

Im Bereich des Kapselmaterials kann der Verguss- oder Verspritzblock einen konkaven Abschnitt, quasi in Form eines Trichters aufweisen. Dieser konkave Abschnitt kann einen zusätzlichen Reflektor bilden. Hierfür kann z.B. ein Verguss- oder Verspritzblockmaterial zum Einsatz kommen, welches bereits über strahlungsreflektierende Eigenschaften verfügt. Auch ist eine entsprechende Beschichtung mindestens im konkaven Abschnitt denkbar. Der Verguss- oder Verspritzblock kann eine Form oder Gestalt aufweisen, die von der Flächenform des Verdrahtungsträgers abweicht. Es ist also möglich, trotz der ausgeprägten Flächenform des Verdrahtungsträgers ohne mechanische Maßnahmen am Verdrahtungsträger selbst einen Modulkörper zu schaffen, der an unterschiedliche Anwendungs- und Einsatzfälle anpassbar ist. Dabei muss letztendlich nur für einen guten Wärmeübergang zwischen Verdrahtungsträgerrückseite, welche frei liegt, und der Umgebung gesorgt werden. Bei einer Ausführungsvariante einer Leuchte wird der anschlussfertige LED-Modulkörper auf einer Leuchtengrundplatte durch Verschrauben befestigt. Diese Leuchtengrundplatte besteht aus einem metallischen oder wärmeleitenden Material relativ großer Flächenausdehnung und ist daher als guter Wärmeleiter und als Wärmesenke bestens geeignet. Eine übliche Leuchtenabdeckung, die am Leuchtengrundkörper befestigt wird, komplettiert dann die Leuchte. Dabei ergibt sich als weiterer Vorteil die insgesamt sehr flachbauende Anordnung.

Die Befestigungsmittel können als Durchbrüche oder Bohrungen zur Aufnahme von Schrauben oder Nieten oder dergleichen Mitteln ausgeführt sein.

Im Bereich der Durchbrüche sind bei einer Ausgestaltung der Erfindung säulenförmige Verstärkungseinsätze aus einem Material vorhanden, das eine größere Härte aufweisen kann, als es bei dem Material des eigentlichen Verguss- oder Verspritzblocks der Fall ist.

Es besteht weiterhin ausgestaltend die Möglichkeit, am Verguss- oder Verspritzblock ein Aufsatzteil mit lichtbündelnder oder lichtstreuender Wirkung zu befestigen. Dieses Aufsatzteil kann eine Kappe sein, die mit Hilfe einer Snap-in-Arretierung am Verguss- oder Verspritzblock - austauschbar - fixierbar ist.

Wie bereits dargelegt, kann der Verguss- oder Verspritzblock Bestandteil eines Leuchtenkörpers sein, der z.B. überwiegend aus einem Kunststoffmaterial besteht und welcher eine Wärmesenke aufweist.

Die Erfindung soll nachstehend anhand eines Ausführungsbeispiels sowie unter Zuhilfenahme von Figuren näher erläutert werden.

Hierbei zeigen:
- Fig. 1: eine Schnittdarstellung durch einen anschlussfertigen LED-Modul- körper;
- Fig. 2: eine Draufsicht auf einen Modulkörper mit kreisförmigem Verguss- oder Verspritzblock und
- Fig. 3: eine Unteransicht des Modulkörpers gemäß Fig. 2 mit erkennbarer freier Rückseite des flächenförmigen Verdrahtungsträgers.

Der LED-Modulkörper gemäß Ausführungsbeispiel geht von einem Verdrahtungsträger 1 aus. Der Verdrahtungsträger 1 ist beispielsweise als keramische Platte ausgeführt.

Auf dem Verdrahtungsträger 1 befinden sich Anschlussfelder 2, die z.B. mittels Siebdruck erzeugt wurden. Zwischen den Anschlussfeldern 2 und dem Diodenchip 3 besteht eine elektrische Verbindung, die im Einzelnen nicht dargestellt ist.

Der mindestens eine Diodenchip 3 ist auf einem Träger 4 befindlich, welcher eine Reflektorfläche 5 aufweist.

Oberhalb der Reflektorfläche 5 ist der Träger 4 und damit auch der Diodenchip 3 mit einem elektrisch isolierenden, lichtdurchlässigen, elastischen oder plastischen Kapselmaterial 6 abgedeckt.

Die vorstehend beschriebene Baueinheit umfasst weiterhin auf dem Verdrahtungsträger 1 angeordnete Strombegrenzungselemente, z.B. Vorwiderstände 7 für den mindestens einen Diodenchip, um über Anschlussmittel 8 einen unmittelbaren Netzbetrieb zu ermöglichen. Die Vorwiderstände 7 können als Chipwiderstände ausgebildet sein.

Die erläuterte Einrichtung umfasst nun weiterhin einen Verguss- oder Verspritzblock 9.

Dieser Verguss- oder Verspritzblock 9 lässt die Unterseite des Verdrahtungsträgers 1 frei. Ebenso wird ein oberseitiger Abschnitt im Bereich des Kapselmaterials 6 nicht mitvergossen oder mitverspritzt. Hier liegt definierter Abstand oder Ringspalt zwischen Verspritzblock 9 und Kapselmaterial 6 vor.

Ansonsten aber umschließt der Verguss- oder Verspritzblock 9 die Anordnung, und zwar unter Einbindung eines Abschnitts 8.1 der Anschlussmittel 8, die z.B. als flexibles Kabel oder aber auch als starrer Leiter ausgeführt werden können. Durch dieses Umschließen der Anschlussmittel 8, aber auch der weiteren elektrischen Komponenten ist der notwendige Berührungsschutz gegeben und der gewünschte Schutzgrad der Anordnung erreichbar.

Außerhalb des flächenförmigen Verdrahtungsträgers 1 ist beim gezeigten Ausführungsbeispiel der Verguss- oder Verspritzblock 9 z.B. mit Durchbrechungen 10 versehen. Diese Durchbrechungen 10 dienen der Aufnahme von jeweils einer Befestigungsschraube 11, um den anschlussfertigen LED-Modulkörper an einer Leuchtenplatte 12, die aus einem Metallmaterial besteht, zu befestigen.

Aus obigen Erläuterungen folgt, dass das Material des Verguss- oder Verspritzblocks 9 elektrisch isolierend ist.

Im Bereich des Kapselmaterials 6 kann der Verguss- oder Verspritzblock 9 einen konkaven Abschnitt 9.1 besitzen.

Dieser konkave Abschnitt 9.1 kann einen zusätzlichen Reflektor darstellen.

Im Bereich der Durchbrüche 10 im Verguss- oder Verspritzblock 9 kann jeweils ein Verstärkungseinsatz 10.1, z.B. in Form einer Hülse befindlich sein. Es ist hierdurch möglich, das Material des Verguss- oder Verspritzblocks 9 mit einer gewissen Elastizität oder Plastizität zu versehen, wobei jedoch durch den Verstärkungseinsatz 10.1 ein sicheres Fixieren der Gesamtanordnung ohne Beschädigung des Blockes 9 erfolgen kann.

Ergänzend kann, z.B. über eine Snap-in-Verbindung, ein transparentes Aufsatzteil 13 am Block 9 befestigt werden.

Dieses Aufsatzteil 13 kann ausgewählte lichtbündelnde oder lichtstreuende Mittel umfassen bzw. eine derartige Wirkung erzeugen, so dass sich die Anwendungsmöglichkeiten des Modulkörpers erweitern. Ergänzend ist ein Schutz gegen Feuchtigkeit oder Verschmutzung gegeben.

Der erfindungsgemäße Modulkörper mit Verguss- oder Verspritzblock kann Bestandteil eines Leuchtenkörpers sein, z.B. in einen Leuchtenkörper integriert werden.

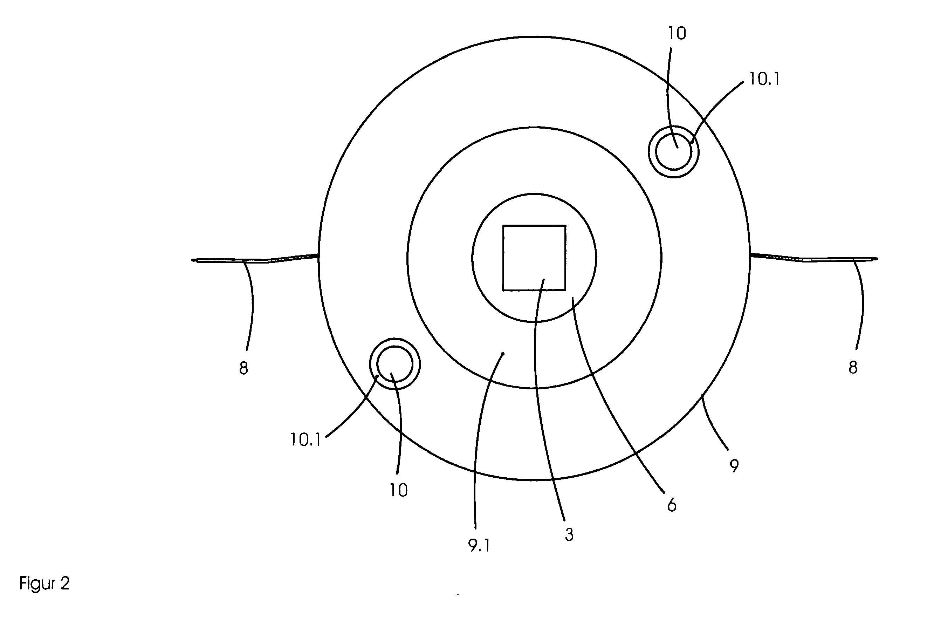

Aus der Draufsicht nach Fig. 2 ist erkennbar, dass der Verguss- oder Verspritzblock 9 z.B. kreisringförmig ausgebildet werden kann. Selbstverständlich sind auch hier abweichende geometrische Formen denkbar.

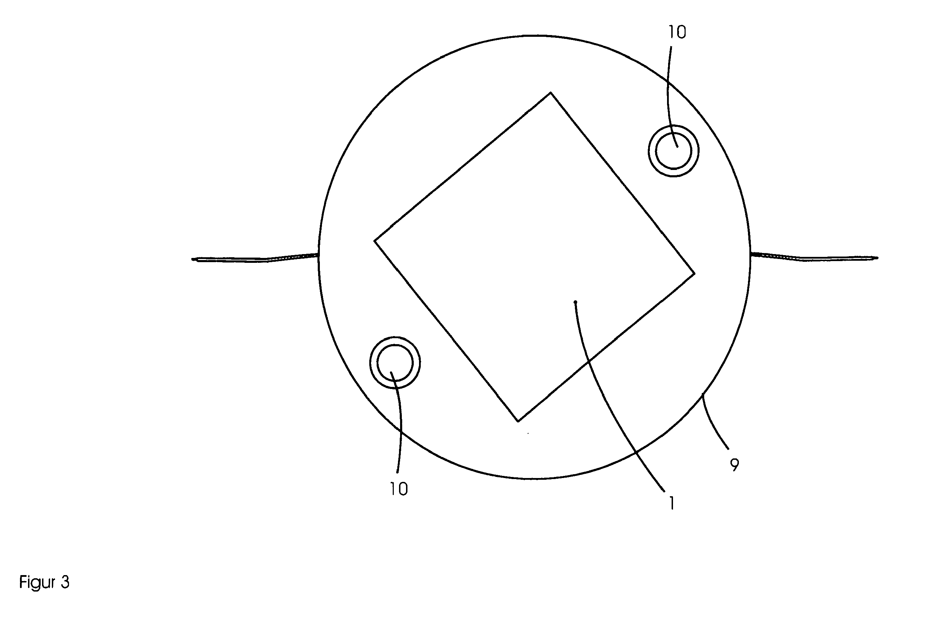

Die Rückseitenansicht des Modulkörpers gemäß Fig. 3 lässt die freiliegende Rückseite des flächenförmigen Verdrahtungsträgers 1 deutlich werden. Die umschreibende Kreisform des Verguss- oder Verspritzblocks 9 ist dabei so gewählt, dass genügend Fläche für die Ausnehmungen 10 bzw. für andere Befestigungsmittel verbleibt.

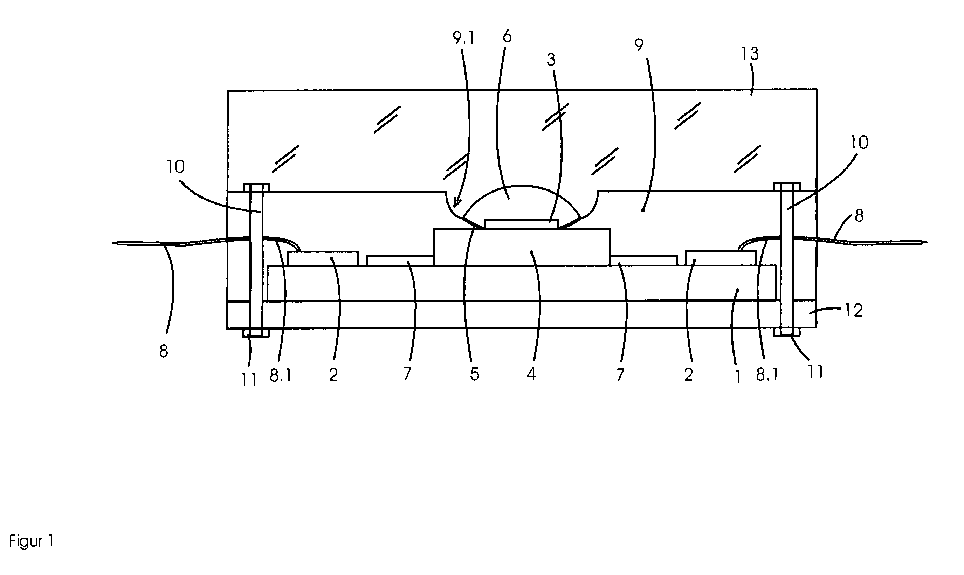

Über die freiliegende, flächenbündige Rückseite mit Verdrahtungsträger 1 ist ein guter Kontakt zu einer Wärmesenke, z.B. zum Teil 12 gemäß Fig. 1 herstellbar.

Es liegt im Sinne der Erfindung, mehrere anschlussfertige LED-Modulkörper gemäß Ausführungsbeispiel auf einem gemeinsamen Tragteil 12 anzuordnen, um dann dieses Tragteil 12, das als gemeinsame Wärmesenke dient, in eine Leuchte zu integrieren.

Aufgrund der fehlenden Vorschaltelektronik, insbesondere einem Netzteil zur Erzeugung einer Kleinspannung, ist der LED-Modulkörper insbesondere für häufig schaltende Beleuchtungsmittel, unmitelbar am Wechselstromnetz in der Niederspannungsverteilung im Bereich von 50 V bis 400 V einsetzbar. Es kann daher ein einfacher Austausch bezogen auf bereits vorhandene Leuchtmittel im Sinne der Energieeinsparung und der Erhöhung der Lebensdauer vorgenommen werden.

## Patentansprüche

1. Anschlussfertiger lichtemittierende Dioden (LED) Modulkörper, umfassend mindestens einen lichtemittierenden Diodenchip (3), welcher auf einem flächenförmigen Verdrahtungsträger (1) angeordnet ist, wobei der mindestens eine Diodenchip (3) mit einem elektrisch isolierenden, lichtdurchlässigen, elastischen oder plastischen Kapselmaterial (6) abgedeckt ist, und Anschlussfeldern (2), die mit dem Diodenchip (3) in elektrischer Verbindung stehen,
wobei
die Anschlussfelder (2) mit einem flexiblen oder starren externen Anschlussmittel (8) kontaktiert sind, auf dem Verdrahtungsträger (1) mindestens ein stromsteuerndes oder strombegrenzendes Element (7) für den mindestens einen Diodenchip (3) angeordnet ist, um über die Anschlussmittel (8) einen unmittelbaren Betrieb an einem üblichen elektrischen Netz zu ermöglichen,
weiterhin ein Verguss- oder Verspritzblock (9) gebildet ist, welcher einen oberseitigen Abschnitt mit dem Kapselmaterial (6) frei lässt sowie die Unterseite des Verdrahtungsträgers (1) thermisch mit der Umgebung koppelbar ausgeführt ist, den Verdrahtungsträger (1) ansonsten vollständig unter Einbindung eines Abschnitts (8.1) der Anschlussmittel (8) umschließt, der Verguss- oder Verspritzblock (9) außerhalb des flächenförmigen Verdrahtungsträgers (1) mindestens ein Mittel (10) zur Befestigung aufnimmt oder aufweist, wobei die Unterseite des Verdrahtungsträgers (1) Bestandteil der thermischen Koppelfläche zu Kühlzwecken ist,
**dadurch** characterisiert, dass
die Anschlussfelder sich auf dem Verdrahtungsträger befinden.

2. Anschlussfertiger LED-Modulkörper nach Anspruch 1,
**dadurch gekennzeichnet, dass**
der Verguss- oder Verspritzblock (9) aus einem elektrisch isolierenden Material besteht und der Diodenchip (3) von einem Reflektor (5) mindestens teilweise umgeben ist.

3. Anschlussfertiger LED-Modulkörper nach Anspruch 1 oder 2,
**dadurch gekennzeichnet, dass**
im Bereich des Kapselmaterials (6) der Verguss- oder Verspritzblock (9) einen konkaven Abschnitt (9.1) aufweist.

4. Anschlussfertiger LED-Modulkörper nach Anspruch 3,
**dadurch gekennzeichnet, dass**
mindestens der konkave Abschnitt (9.1) einen zusätzlichen Reflektor bildet.

5. Anschlussfertiger LED-Modulkörper nach einem der vorangegangenen Ansprüche,
**dadurch gekennzeichnet, dass**
der Verguss- oder Verspritzblock (9) eine Form besitzt, die von der Flächenform des Verdrahtungsträgers abweicht.

6. Anschlussfertiger LED-Modulkörper nach einem der vorangegangenen Ansprüche,
**dadurch gekennzeichnet, dass**
die Befestigungsmittel als Durchbrüche (10) zur Aufnahme von Schrauben oder Nieten (11) ausgeführt sind.

7. Anschlussfertiger LED-Modulkörper nach Anspruch 6,
**dadurch gekennzeichnet, dass**
im Bereich der Durchbrüche (10) jeweils ein Verstärkungseinsatz (10.1) angeordnet und im Verguss- oder Verspritzblock (9) eingebettet ist.

8. Anschlussfertiger LED-Modulkörper nach einem der vorangegangenen Ansprüche,
**dadurch gekennzeichnet, dass**
am Verguss- oder Verspritzblock (9) ein Aufsatzteil (13) mit lichtbündelnder oder lichtstreuender Wirkung befestigbar ist.

9. Anschlussfertiger LED-Modulkörper nach einem der vorangegangenen Ansprüche,
**dadurch gekennzeichnet, dass**
dieser in einen Leuchtenkörper integriert ist.

10. Anschlussfertiger LED-Modulkörper nach Anspruch 9,
**dadurch gekennzeichnet, dass**
der Verguss- oder Verspritzblock (9) Bestandteil eines Leuchtenkörpers ist.

11. Anschlussfertiger LED-Modulkörper nach einem der vorangegangenen Ansprüche,
**dadurch gekennzeichnet, dass**
als stromsteuerdes Element Vorwiderstände, Zener-Dioden oder dergleichen Bauelemente eingesetzt sind.

12. Anschlussfertiger LED-Modulkörper nach einem der vorangegangenen Ansprüche,
**dadurch gekennzeichnet, dass**
die Unterseite des Verdrahtungsträgers (1) von Kapselmaterial (6) freigelassen ist.

13. Verwendung eines anschlussfertigen LED-Modulkörper einem der Ansprüche 1 bis 8 oder 11 und 12
als Leuchtmittel einer Leuchte, welche unmittelbar an einem Wechselstrom-Niederspannungsnetz betreibbar ist.

## Claims

1. Ready-to-connect light-emitting diodes (LED) module body, comprising at least one light-emitting diode chip (3) which is arranged on a flat wiring carrier (1), wherein the at least one diode chip (3) is covered with an electrically insulating, transparent, elastic or plastic encapsulating material (6), and connector panels (2) that are electrically connected to the diode chip (3), wherein the connector panels (2) are contacted with a flexible or rigid external connection means (8), at least one current-controlling or current-limiting element (7) for the at least one diode chip (3) is arranged on the wiring carrier (1) in order to allow a direct operation on a conventional electric network via the connection means (8), wherein further a cast or injection-molded block (9) is formed which spares a top side section with the encapsulating material (6) and the bottom side of the wiring carrier (1) is adapted to be thermally coupleable to the environment whilst completely surrounding the wiring carrier (1) by integrating a section (8.1) of the connection means (8), the cast or injection-molded block (9) receives or is provided with at least one fixing means (10) outside the flat wiring carrier (1), wherein the bottom side of the wiring carrier (1) is part of the thermal coupling surface for cooling purposes, **characterized in that**
the connector panels are located on the wiring carrier.

2. Ready-to-connect LED module body according to claim 1,
**characterized in that**
the cast or injection-molded block (9) is made of an electrically insulating material and the diode chip (3) is at least partially surrounded by a reflector (5).

3. Ready-to-connect LED module body according to claim 1 or 2,
**characterized in that**
the cast or injection-molded block (9) includes a concave section (9.1) in the area of the encapsulating material (6).

4. Ready-to-connect LED module body according to claim 3,
**characterized in that**
at least the concave section (9.1) forms an additional reflector.

5. Ready-to-connect LED module body according to one of the preceding claims,
**characterized in that**
the cast or injection-molded block (9) has a shape that deviates from the surface shape of the wiring carrier.

6. Ready-to-connect LED module body according to one of the preceding claims,
**characterized in that**
the fixing means are designed as openings (10) to receive screws or rivets (11).

7. Ready-to-connect LED module body according to claim 6,
**characterized in that**
in the area of the openings (10) a reinforcing insert (10.1) is arranged and embedded in the cast or injection-molded block (9).

8. Ready-to-connect LED module body according to one of the preceding claims,
**characterized in that**
a mount-on part (13) having a light-concentrating or light-diffusing effect can be fixed to the cast or injection-molded block (9).

9. Ready-to-connect LED module body according to one of the preceding claims,
**characterized in that**
the ready-to-connect LED module body is integrated in a lighting fixture.

10. Ready-to-connect LED module body according to claim 9,
**characterized in that**
the cast or injection-molded block (9) is part of a lighting fixture.

11. Ready-to-connect LED module body according to one of the preceding claims,
**characterized in that**
series resistors, Zener diodes or the like components are used as current-controlling element.

12. Ready-to-connect LED module body according to one of the preceding claims,
**characterized in that**
the bottom side of the wiring carrier (1) is spared by encapsulating material (6).

13. Use of a ready-to-connect light-emitting diodes (LED) module body according to one of claims 1 to 8 or 11 and 12 as an illuminant of a light, which is directly operable on an alternating current low-voltage network.

## Revendications

1. Corps modulaire prêt à raccorder pour diode électroluminescente (DEL), comprenant au moins une puce-diode électroluminescente (3), qui est agencée sur un support de câblage (1) de forme surfacique, ladite au moins une puce-diode (3) étant recouverte d'un matériau d'encapsulation (6) électriquement isolant, transparent à la lumière, élastique ou plastique, et des champs de raccordements (2) qui sont en connexion électrique avec la puce-diode (3),
dans lequel
les champs de connexion (2) sont en contact avec un organe de connexion externe (8) flexible ou rigide, au moins un élément (7) de commande de courant ou de limitation de courant est agencé sur le support de câblage (1) afin de permettre via l'organe de connexion (8) un fonctionnement direct sur un réseau électrique classique,
il est en outre formé un bloc coulé ou injecté (9), qui dégage un tronçon supérieur avec le matériau d'encapsulation (6) et qui est réalisé de façon à pouvoir accoupler la face inférieure du support de câblage (1) de manière thermique avec l'environnement, mais qui enferme par ailleurs le support de câblage (1) en totalité en intégrant un tronçon (8.1) de l'organe de connexion (8), le bloc coulé ou injecté (9) recevant ou comportant, à l'extérieur du support de câblage (1) de forme surfacique, au moins un moyen (10) pour la fixation, et la face inférieure du support de câblage (1) est une partie constitutive de la surface d'accouplement thermique destinée à des fins de refroidissement, **caractérisé en ce que** les champs de connexion se trouvent sur le support de câblage.

2. Corps modulaire prêt à raccorder pour diode électroluminescente selon la revendication 1,
**caractérisé en ce que** le bloc coulé ou injecté (9) est en un matériau électriquement isolant, et la puce-diode (3) et au moins partiellement entourée par un réflecteur (5).

3. Corps modulaire prêt à raccorder pour diode électroluminescente selon la revendication 1 ou 2,
**caractérisé en ce que** le bloc coulé ou injecté (9) comprend un tronçon concave (9.1) dans la région du matériau d'encapsulation (6).

4. Corps modulaire prêt à raccorder pour diode électroluminescente selon la revendication 3,
**caractérisé en ce que** le tronçon concave (9.1) au moins forme un réflecteur additionnel.

5. Corps modulaire prêt à raccorder pour diode électroluminescente selon l'une des revendications précédentes,
**caractérisé en ce que** le bloc coulé ou injecté (9) possède une forme qui s'écarte de la forme surfacique du support de câblage.

6. Corps modulaire prêt à raccorder pour diode électroluminescente selon l'une des revendications précédentes,
**caractérisé en ce que** le les organes de fixation sont réalisés sous forme de traversées (10) pour la réception de vis ou de rivets (11).

7. Corps modulaire prêt à raccordés pour diode électroluminescente selon la revendication 6,
**caractérisé en ce qu'**un insert de renforcement respectif (10.1) est agencé dans la région des traversées (10) et noyé dans le bloc coulé ou injecté (9).

8. Corps modulaire prêt à raccorder pour diode électroluminescente selon l'une des revendications précédentes,
**caractérisé en ce qu'**une partie rapportée (13) présentant un effet de focalisation ou de diffusion de la lumière est susceptible d'être fixée sur le bloc coulé ou injecté (9).

9. Corps modulaire prêt à raccorder pour diode électroluminescente selon l'une des revendications précédentes,
**caractérisé en ce que** celui-ci est intégré dans un corps de lampe.

10. Corps modulaire prêt à raccorder pour diode électroluminescente selon la revendication 9,
**caractérisé en ce que** le bloc coulé ou injecté (9) est une partie constitutive d'un corps de lampe.

11. Corps modulaire prêt à raccorder pour diode électroluminescente selon l'une des revendications précédentes,
**caractérisé en ce que** l'on emploie à titre d'éléments de commande de courant des résistances à ballast, des diodes Zener ou des composants similaires.

12. Corps modulaire prêt à raccorder pour diode électroluminescente selon l'une des revendications précédentes,
**caractérisé en ce que** la face inférieure du support de câblage (1) est dégagée du matériau d'encapsulation (6).

13. Utilisation d'un corps modulaire prêt à raccorder pour diode électroluminescente selon l'une des revendications 1 à 8 ou 11 et 12 à titre d'organe d'éclairage d'une lampe, qui peut être utilisé directement sur un réseau alternatif à basse tension.
